(19) Europäisches Patentamt / European Patent Office / Office européen des brevets

(11) **EP 2 653 874 A1**

(12) **EUROPEAN PATENT APPLICATION**

(43) Date of publication:
**23.10.2013 Bulletin 2013/43**

(51) Int Cl.:
**G01R 15/04** (2006.01)  **G01R 31/36** (2006.01)

(21) Application number: **13163782.9**

(22) Date of filing: **15.04.2013**

| | |
|---|---|
| (84) Designated Contracting States:<br>**AL AT BE BG CH CY CZ DE DK EE ES FI FR GB GR HR HU IE IS IT LI LT LU LV MC MK MT NL NO PL PT RO RS SE SI SK SM TR**<br>Designated Extension States:<br>**BA ME**<br><br>(30) Priority: **19.04.2012 IT MI20120656** | (71) Applicant: **Cantone, Andrea**<br>**25050 Rodengo-Saiano (BS) (IT)**<br><br>(72) Inventor: **Cantone, Andrea**<br>**25050 Rodengo-Saiano (BS) (IT)**<br><br>(74) Representative: **Galassi, Alessandro**<br>**Ponzellini Gioia e Associati S.R.L.**<br>**Via Mascheroni, 31**<br>**20145 Milano (IT)** |

(54) **Electronic circuit, in particular for a battery management system**

(57)     An electronic circuit (1), in particular for a battery management system, the circuit comprising: at least an input (Vn; Vp), destined to be connected to a voltage source located upstream of the circuit; at least an electronic amplifier (10), provided with at least a positive input terminal (11), a negative input terminal (12) and a voltage output (13) and possibly a voltage reference (Vref), the input being electrically connected to the positive input terminal or the negative input terminal; at least a voltage divider (20) interposed between, and connected with, the at least an input and one from among the positive input terminal and the negative input terminal. The circuit further comprises at least an analog switch (30) operatively connected in series to the at least a voltage divider and selectively operable at least between a closed condition, in which it enables passage of electric current from the at least an input to the electronic amplifier, and an open condition, in which it interrupts passage of electric current from the at least an input to the electronic amplifier. The electronic amplifier is an operational amplifier or and instrumentation amplifier; the analog switch is a bipolar junction transistor (BJT), a field effect transistor (FET) or a relay.

FIG.1

**Description**

The present invention relates to an electronic circuit, destined in particular, though not exclusively, for a battery management system. In greater detail, the invention relates to an electronic circuit comprising one or more amplifiers, operations, differential or instrumentation, and one or more analog switches. A differential amplifier, like an instrumentation amplifier, is an electronic circuit, made up by operational amplifiers, provided with two inputs (denoted as positive - or "non-inverting" and negative - or "inverting") and an output and able to amplify and/or translate in level the voltage difference between the two inputs and to supply a corresponding signal at the output. The amplifier exhibits a very high input towards the two inputs; in particular, in a case of an instrumentation amplifier, the impedance is nominally infinite. Labelling the two inputs $V^+$ e $V^-$, a differential amplifier supplies an output $V_{out}$: $V_{out} = A_d (V^+ - V^-) + A_c ((V^+ + V^-)/2)$, in which $A_d$ is called "differential mode gain" and $A_c$ is termed "common mode gain".

In substance, the differential mode gain indicates how the amplifier transmits to the output (changing the amplitude thereof) the difference between the voltages, i.e. the signal which is to be "processed", while the common mode gain amplifies the arithmetical mean between the input voltages and for this reason, typically bearing more on the output, can "cover" - by hiding - the difference between the voltages; further, the common mode gain tends to amplify each summed signal equally at the two inputs, as is typically the case of disturbances on the inputs.

With the aim of making the circuit immune to the amplifying effect on the common mode voltage, the $A_c$ must as far as possible tend to 0 and especially must be constant both in time and with respect to the operating conditions, such as to be liable to easy calibration, preferably numerically. In this way the output of the amplifier tends to $V_{out} = A_d$ $(V^+ - V^-)$ and the CMRR, or "*common mode rejection ratio*", defined as the ratio between the differential mode gain and the common mode gain tends to the infinite. In this ideal condition the output signal would depend exclusively on the difference between the input signals. The differential amplifiers and the instrumentation amplifiers are used in a wide variety of electronic circuits. Among these are the control circuits for batteries made up of a plurality of cells, in which a differential amplifier can be used for reading the voltage of a single cell by means of an electronic circuit referring to the negative pole of the battery. This is the case of the BMS (Battery Management System), an electronic system for controlling rechargeable batteries, which monitors the state of the battery (voltage and current values, temperature, state of recharging, etc,) and managing the dispensing of electrical energy and recharging.

This system is used for example in lithium rechargeable batteries, made in digital form and a considerable part thereof relates to the voltage of the negative pole. In the field of BMS, use is known  of dedicated integrated circuits, completely analog, not deactivatable, which absorb currents of the order of tens of pA and with an accuracy in the order of tens of mV.

Also known are dedicated digital integrated circuits, which absorb currents of the order of tens of pA, and are limited to common mode currents of a few tens of volts; these circuits have an accuracy that is typically of the order of tens of mV.

Also known is recourse to analog differential amplifiers provided with a non-switchable input impedance.

Lastly at present resistive dividers with analog switches are used, followed directly or via a multiplexer, by a step of analog/digital conversion; the voltage difference between the two inputs is therefore calculated in the digital dominion.

The Applicant has however found that electronic circuits at present available, in particular destined to a battery management system, are not free of drawbacks and can be improved in various aspects. In greater detail, the Applicant has found how in the known electronic circuits the current in the inputs of the operations amplifier or amplifiers, used for measuring the voltage values of the cells, cannot be annulled.

A further drawback of the known circuits relates to the poor precision and/or resolution of the calculation of the voltages in the cells of a battery. Also, in known circuits the resistive network about the operational amplifier lowers the CMRR value (common mode rejection ratio), i.e. makes the operational amplifier sensitive to the common mode, and this prevents detection of a small fluctuation in the voltage with respect to a base value, typically high, and operating with precision when the relevant information is contained in the voltage different between the two inputs.

A further drawback of known circuits consists in the difficulty of interfacing with digital circuitry, typically positioned downstream with respect thereto and to which the signals processed by the circuit itself are destined.

The Applicant has also observed how the use of dedicated integrated circuits causes the absence of compatible or replaceable components, necessary for the maintaining or repairing of faults, and/or a difficulty in supplying the components of the circuit, typically manufactured by a single supplier for the specific application. In substance, the known circuits are typically specifically designed for a particular application and it is extremely difficult to make modifications and adapt the circuit to other applications. In this situation, in particular in the light of the above-illustrated drawbacks, the aim at the base of the present invention, in its various aspects and/or embodiments, is to provide an electronic circuit, destined in particular though not exclusively, for a battery management system, which can obviate one or more of the mentioned drawbacks.

In particular, the Applicant has found that obviating the above-described problems represents a primary objective, as the differential and instrumentation amplifiers are used in a large variety of electronic circuits, in particular in all cases in which the two following conditions are contemporaneously satisfied: a need to amplify with high precision (in terms of accuracy and repeatability) and resolution a small voltage summed to a large common mode voltage; a need to be able to disable or disconnect ("open") the circuit in order to annul the current flowing in the inputs thereof, for example for applications in the field of batteries or for preventing galvanic effects. In fact in this type of system it is necessary to monitor the voltage of the single cells (typically from 2.7V to 4.2V), which however are summed to the voltage of the underlying cells, which can reach several hundreds of volts. Further, it is highly desirable to be able to annul, or at least strongly reduce, the current absorbed when the battery is not used, with the aim of both increasing the autonomy times and preserving the charge of the battery when not used or recharged for a long time, which can occur in traction or propulsion applications in general, or in portable instruments for seasonal use. In these cases, even small currents (for example of the order of 10-100$\mu$A) over long times (for example months or years) can lead to complete discharging or damage to batteries, even those having high capacity.

Definitely, a technical aim of the invention is to make available an electronic circuit characterised at the same time by a high precision in measuring differential voltages and by the ability to interrupt the current circulating therein, increasing the CMRR value. A further object of the invention is to make available an electronic circuit that is simple and/or economical in terms of design and/or realization and/or maintenance and/or characterised by high efficiency.

This aim, and other aims too, which will more fully emerge during the course of the following description, is substantially attained by an electric circuit, in particular for a battery managing system, according to one or more of the accompanying claims, each of which taken alone (without the relative dependencies) or in any combination with the other claims, as well as according to the following aspects and/or embodiments, variously combined, also with the above-mentioned claims.

In an aspect the invention relates to an electronic circuit, in particular for battery management system, the circuit comprising:

- at least an input, destined to be connected to a voltage source located upstream of the circuit;
- at least an electronic amplifier, provided with at least a positive input terminal, a negative input terminal and a voltage output, said at least an input being electrically connected to said positive input terminal or said negative input terminal;
- at least a voltage divider interposed between, and connected with, said at least an input and one from among said positive input terminal and said negative input terminal;

the circuit further comprising at least an analog switch operatively connected in series to said at least a voltage divider and selectively operable at least between a closed condition, in which it enables passage of electric current from said at least an input to said electronic amplifier, and an open condition, in which it interrupts passage of electric current from said at least an input to said electronic amplifier.

In an aspect, the electronic amplifier is an operational amplifier or an instrument amplifier. The circuit, as a whole realizes a differential amplifier. As illustrated above, by the expression "operational amplifier" relates to an electronic amplifier equipped with a positive input terminal, a negative input terminal and a voltage output and is able to supply at the output a signal corresponding to the voltage difference present between the two input terminals multiplied by an amplification coefficient.

In the present invention, the expression "instrumentation amplifier" relates to a type of operation amplifier that is particularly suitable for performing electronic measurement and in professional instrumentation. The structure thereof can be considered a branching of the differential amplifier: in fact it comprises two inputs (positive and negative) and a voltage output, but is realised by means of three distinct operational amplifiers, two of which are connected singly respectively to the positive input and the negative input, and connected to one another, while the third is arranged downstream of the first two and connected by the two inputs thereof to the two outputs of the first two amplifiers. The architecture of the instrumentation amplifier advantageously enables increasing the input impedance of the circuit and varying the amplification of the input voltage differential. Alternatively it is further possible to realize an instrumentation amplifier even with only two operational amplifiers.

In an aspect the at least an analog switch can preferably be a bipolar junction transistor (BJT), a field effect transistor (FET), preferably a MOSFET, a MESFET or a JFET, or a relay.

In substance, the analog switch functions, internally of the circuit, as a switch controllable to selectively open and close the branch of the circuit - in which it is inserted - which connects the input to the electronic amplifier and, via the amplifier, to the output of the circuit; in this way, with the switches open the positive and negative inputs will be disconnected from the voltage output, while, on the contrary, with the switches closed the positive and negative inputs will be connected to the voltage output. In other words, the switch enables selectively interrupting the divider at the input of the circuit. This means that the electronic amplifier is switchable, i.e. activatable or deactivatable, by means of the two switches. The electronic circuit of the invention has finite input impedance and the switches enable making it almost infinite when the circuit is off, or when a differential voltage measured is not required. In an aspect, the circuit comprises a positive input and a negative input, destined to be connected respectively to a source of positive voltage and a source of negative voltage upstream of the circuit, and said electronic amplifier is an operational amplifier, where the positive input terminal and the negative input terminal of the operational amplifier are electrically connected respectively with said positive input and said negative input, the circuit further comprising a first voltage divider interposed between, and connected with, the positive input and said positive input terminal, and a second voltage divider interposed between, and connected with, the negative input and said negative input terminal, the circuit further comprising a first analog switch and a second analog switch which are part of the series constituting respectively said first voltage divider and said second voltage divider, said first and second analog switches being selectively and independently operable at least between said closed condition and said open condition, respectively to enable or interrupt passage of electric current via said divider and to selectively provide the operational amplifier with a valid signal for the measurement from the respective input to said operational amplifier.

Where the voltage sources originate from a battery, i.e. the electronic circuit is connected to a battery, the positive and negative voltage sources are typically two positive sources, on greater than the other; in this case the positive and negative voltage sources are respectively the larger and smaller of the two voltages of the battery. In substance, in the embodiment described in the above aspect, the invention is based on an operational amplifier with dividers in input (to increase the difference in a common way), two analog switches (preferably MOSFETs with an adequate breakdown voltage or BJTs or relays) are placed in series at the two input resistors. The use of analog switches realized with BJT transistors can be advisable, for example, for applications that do not require high precision, such as managing lead batteries. In this case the use of BJT switches enables reducing manufacturing costs of the electronic circuit.

In a further aspect, the circuit of the present invention comprises at least a first and a second input, destined to be connected respective to a first voltage source and a second voltage source upstream of the circuit, and the electronic amplifier is an instrumentation amplifier, where the positive input terminal and the negative input terminal of the instrumentation amplifier are electrically connected respectively with the first input and second input, the circuit further comprising a first voltage divider interposed between, and connected with, the first input and the positive input terminal, and a second voltage divider interposed between, and connected to, the second input and the negative input terminal, the circuit further comprising a first analog switch and a second analog switch, connected in series respectively to the first voltage divider and the second voltage divider, the first and second analog switch being selectively and independently operable at least between the closed condition and the open condition, in order to enable or interrupt the passage of electric current from the input to the instrumentation amplifier.

In substance, in the embodiment described in the above aspect, the invention is based on an instrumentation amplifier with a resistive divider in input for each node (cell) to be acquired. The divider comprises, in series, an analog switch, typically - but not exclusively - placed just above the output node of the divider. In an independent aspect the invention relates to a battery management system comprising a plurality of the electronic circuit, each destined to be connected to a respective cell of an electric battery.

The present invention can be advantageously applied to managing batteries and banks of super-condensers.

The described circuit can be realised in both integrated form and as discrete components.

Further characteristics and advantages will more fully emerge from the detailed description of some embodiments, among which also a preferred embodiment, by way of non-exclusive examples, of an electronic circuit, in particular for a battery management system, according to the present invention. The description will be set out in the following with reference to the accompanying figures of the drawings, provided by way of non-limiting example, in which:

- figure 1 is a general schematic representation of an electronic circuit according to the present invention;
- figure 2 is a schematic representation of a possible embodiment of a portion of the electronic circuit of figure 1, in particular the block denoted by number 20;
- figure 3 is a schematic representation of a further possible embodiment of a portion of the electronic circuit of figure 1, in particular the block denoted by number 20;
- figure 4 is a circuit diagram of a first embodiment of an electronic circuit according to the present invention;
- figure 5 is a circuit diagram of a second embodiment of an electronic circuit according to the present invention.

With reference to the accompanying figures of the drawings, an electronic circuit of the present invention is denoted in its entirety by reference number 1. In general, the same reference number is used for identical or similar elements, possibly in their further embodiments.

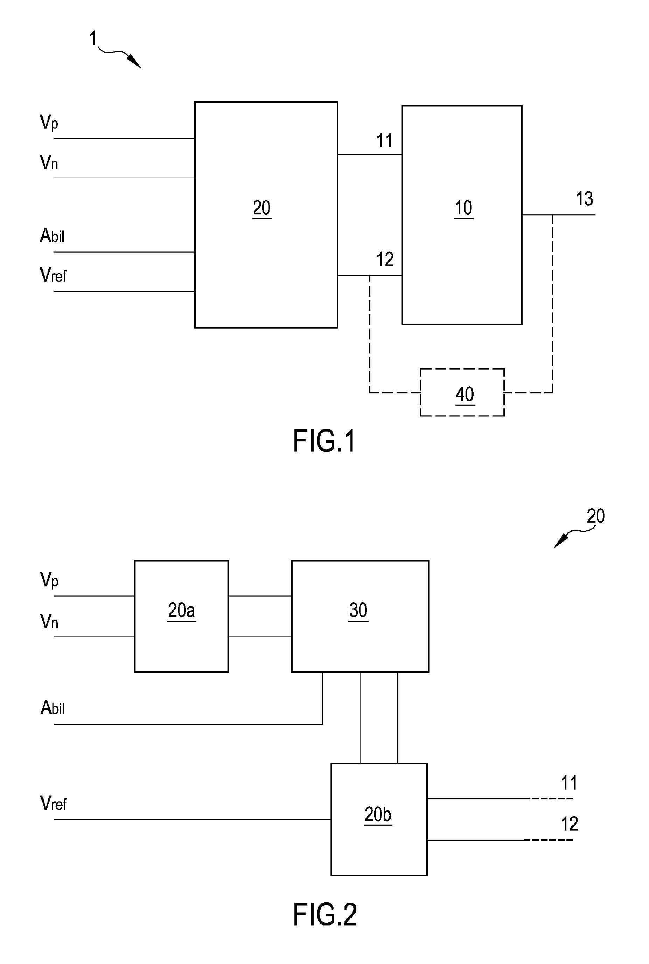

In its most general embodiment schematised in figure 1, the electronic circuit 1 comprises: at least an input Vn; Vp, destined to be connected to a voltage source located upstream of the circuit; at least an electronic amplifier 10, provided with at least a positive input terminal 11, a negative input terminal 12 and a voltage output 13 and possibly a voltage reference Vref, where the at least an input is electrically connected to said positive input terminal or said negative input terminal; at least a voltage divider 20 interposed between, and connected with, said at least an input and one from among said positive input terminal and said negative input terminal. The circuit further comprises at least an analog switch denoted by 30 operatively connected in series to the voltage divider 20 and selectively operable at least between a closed condition, in which it enables passage of electric current from the input to the electronic amplifier, and an open condition, in which it interrupts passage of electric current from said at least an input to said electronic amplifier, In other words, the switch "splits" the divider and enables selective activation and deactivation of the electronic circuit.

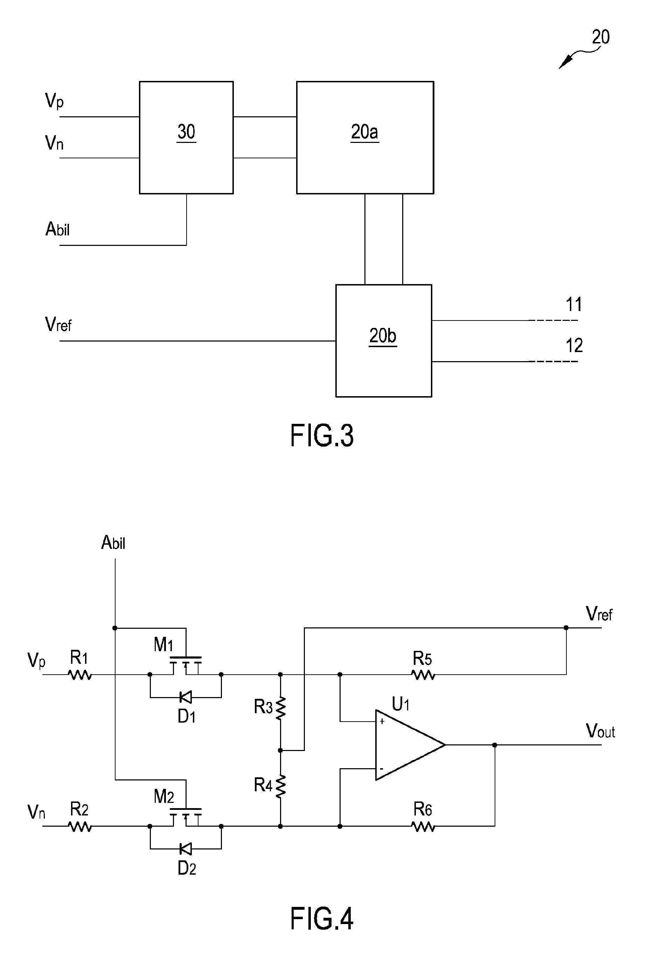

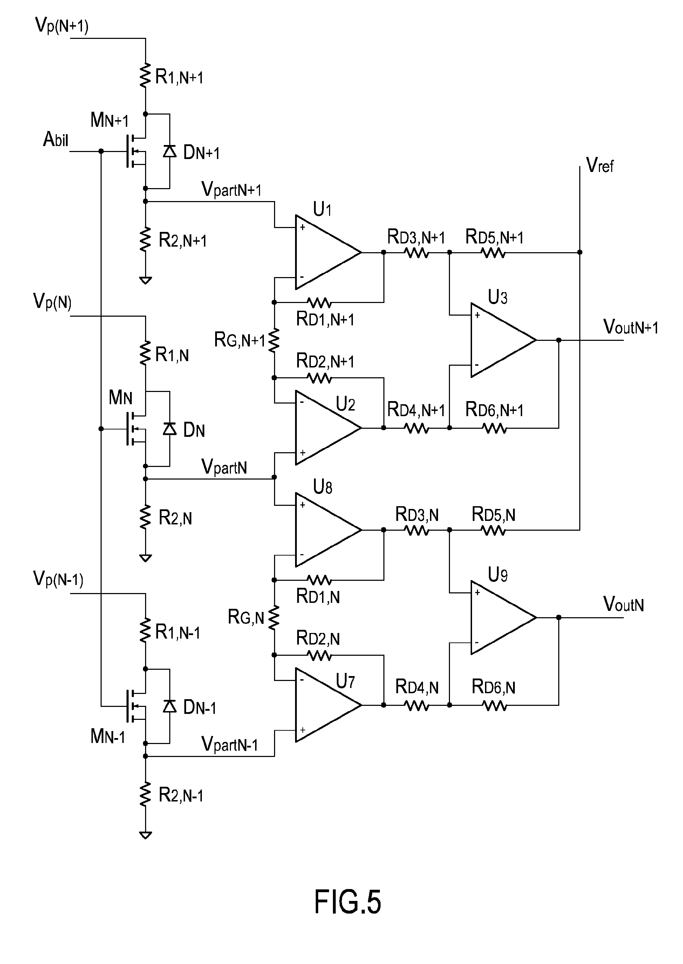

The electronic amplifier is preferably an operational amplifier (figure 4) or an instrumentation amplifier (figure 5).

The analog switch 30 is a bipolar junction transistor (or BJT), a field effect transistor (or FET), preferably a MOSFET, a MESFET or a JFET, or a relay.

The voltage reference Vref can be explicit, in a case in which the output is to be translated about the reference, or, alternatively, it can be implicit (or hidden) when connecting the reference at 0V.

Figure 2 illustrates a schematic representation of a portion of the general electronic circuit diagram of figure 1, in particular the divider block, denoted by number 20. In this configuration, developed concretely in the example circuit of figure 4, described more fully in the following, the switch 30 is inserted in the voltage divider 20 between a first portion thereof (or "high divider", denoted by reference numeral 20a) connected to the inputs Vp and Vn and a second portion thereof (or "lower divider", denoted by reference numeral 20b), connected to voltage reference Vref. In other words, the switch is connected both to the high divider and the low divider and is positioned above the divider output, which connect to the input terminals 11 and 12 of the amplifier positioned downstream of the divider.

Figure 3, on the other hand, is a schematic representation of a different realisation of the divider block, denoted by numeral 20, of the general electronic circuit divider of figure 1. In this configuration the switch 30 is inserted in the voltage divider 20 "upstream" of both the high divider 20a and the low divider 20b. The switch receives the inputs Vp and Vn and is connected in output to the high divider; the low divider is positioned downstream of the high divider and is connected to the voltage reference Vref. This configuration can be defined as the voltage divider 20 with a switch at the input.

In both cases, i.e. figures 2 and 3, the switch 30 is connected to an enabling line (denoted in the figures by "Abil" which supplies it and determines functioning thereof.

In the embodiment of figure 4, which extends the functional diagram of figure 1 and shows a circuit diagram for implementing the circuit of the invention, the circuit comprises positive input Vp and a negative input Vn, destined to be connected respectively to a source of positive voltage and a source of negative voltage upstream of the circuit, and the electronic amplifier is an operational amplifier U1. As indicated herein above, the two voltage sources can both be positive (as is typically the case in batteries); in this case Vp is the greater of the two positive sources and Vn is the lesser of the two positive sources; the fact that Vp and Vn are one positive and the other negative or both positive does not influence the overall functioning of the circuit.

Further, the positive and negative input terminals of the operational amplifier are electrically connected respectively with the positive and negative input.

In this embodiment, the circuit further comprises: a first voltage divider R1, R3 interposed between, and connected with, the positive input and the positive input terminal; a second voltage divider R2-R4 interposed between and connected with the negative input and the negative terminal input; a first analog switch M1 and a second analog switch M2, connected in series respectively to the first and second voltage divider. The first and second analog switches are selectively and independently operable at least between the closed and open conditions, such as to enable or interrupt passage of electric current from the respective input to the operational amplifier.

The positive input and the negative input are preferably electrically connected respectively to the source of positive voltage and said source of negative voltage upstream of the circuit, the sources of positive and negative voltage being the output terminals of a battery or of a single cell of a battery (not illustrated, for example a lithium battery or another battery of known type). As already indicated, in the case of a battery connected to the electronic circuit, both the voltage sources are positive (with Vp greater than Vn); alternatively, Vp and Vn can be connected respectively to the positive or negative terminals of a cell of a battery.

The first voltage divider preferably comprises a first R1 and a third electrical resistor R3 connected in series to the positive input and the second voltage divider comprises a second R2 and a fourth electrical resistor R4 connected in series to the negative input. Observe that the resistors R1 and R3 are not electrically in series, in the sense that the R1 current does not enter the input of the operational amplifier; however they are not to be considered in series from the logical point of view and from that of the flow of the information. In greater detail, as shown in figure 4, the positive input terminal of the operational amplifier is connected in an intermediate position between the first and third electrical resistor and the negative input terminal of the operational amplifier is connected in an intermediate position between the second and the fourth electrical resistor.

The circuit 1 preferably comprises a voltage reference Vref (or reference voltage), connected to the positive input terminal of the operational amplifier, and a fifth electrical resistor R5 interposed in series to the reference voltage and the positive terminal input.

This voltage reference is preferably connected to a common point downstream of the third and fourth electrical resistor.

The circuit preferably comprises a feedback line 40 connecting the voltage output 13 and the negative input terminal of the operational amplifier. The circuit preferably comprises, in series with the feedback line, a sixth electrical resistor R6.

The first analog switch is preferably interposed in series between the first and the third electrical resistor and the second analog switch is interposed in series between the second and the fourth electrical resistor.

The electronic circuit preferably comprises an independent supply line (denoted in the figures with reference "Abil") connected to the first and second analog switch for determining passage between the open condition and the closed condition.

The Applicant has found that the architecture of the circuit with the operational amplifier advantageously enables minimising the number of operational amplifiers used for performing the voltage measurements, and in general for the control of an electric battery composed of a plurality of cells.

In the following, a detailed description and analysis is given of the functioning of the electronic circuit in the embodiment which includes use of an operational amplifier, with particular reference to the functions of transfer between inputs and outputs, relations between voltages, currents and resistors, and the effects caused by non-ideal components of the circuit.

Considering the described circuit, and for the moment leaving aside the presence of the analog switches, it is observed that in the "classic" amplifier, i.e. "not-switched", the connection to two voltage sources (positive and negative inputs) is such that there is always a current flowing in the input terminals of the amplifier, even in a case in which it is not powered. In fact the third R3, fourth R4 and fifth R5 resistor, as well as the protection diodes internal of the amplifier, provide paths towards the negative voltage input (typically connected upstream of the negative pole of the battery). The current which flows in these paths is quantifiable in the voltage at the two inputs, divided by the resistor observed towards the inputs (about the first resistor R1 summed to the third resistor R3, and thus the first resistor R1 as it is dominant). Typically these currents can have a value up to various tens of pA (for example 80μA for an input current of 80V with a resistor of 1MΩ). The cumulative effect of several reading stages, i.e. several flanked circuits, applied for long periods, can lead to absorption of quantities of charge that are a relevant fraction of the rated capacity of the battery.

The presence of the first and second analog switch enables, when they are in the open condition, drastically reduces the currents that flow in the amplifier inputs; on the contrary, when the switches are in the closed condition they disturb minimally - and in a way that can be compensated by calibration - the functioning of the amplifier and equate, internally of the circuit, to a resistance that is much lower than the others, and typically insignificant. The entity of the reduction of input current depends on the type of analog switch and thus on design choices. For example, a MOSFET in a 200V SOT-23 *package* (for example the commercial product coded ZVN3320), at a voltage of 80V and at environmental temperature exhibits about 4μA of current loss, which is 20 times better with respect to the known solutions, and at the same time enables a very compact realization of the circuit (for example a double-sided printed circuit of dimensions 28mm x 24mm can house up to 4 electronic circuits). By using relays as analog switches even smaller currents can be obtained (effectively nil) as well as the possibility to process negative input voltages; however the circuit is much less compact and can suffer from problems typical of the electromechanical systems.

With reference to figure 4, and considering active and ideal analog switches (i.e. MOSFETs having a nil resistance to passage of the current between *drain* and *source*, in linear region), the resistance can be calculated by observing the positive input, closing the circuit of the voltage reference:

$$R_p = R_1 + R_3 \parallel R_5 = \frac{R_1 R_3 + R_1 R_5 + R_3 R_5}{R_3 + R_5}$$

The voltage at the negative terminal of the operational amplifier is:

$$V_{OAp} = V_{ref} + (V_p - V_{ref}) \cdot \frac{R_3 \parallel R_5}{R_1 + R_3 \parallel R_5} = V_{ref} + (V_p - V_{ref}) \cdot \frac{R_3 R_5}{R_1 R_3 + R_1 R_5 + R_3 R_5}$$

The operational amplifier (ideal and not saturated or in slew rate limitation) imposes that the voltages at the two inputs, positive and negative, be identical:

$$V_{OAn} = V_{OAp}$$

The current flowing in R2 towards the negative input of the operational is:

$$I_2 = \frac{V_n - V_{OAn}}{R_2} = \frac{V_n(R_1 R_3 + R_1 R_5 + R_3 R_5) - V_{ref} R_1(R_3 + R_5) - V_p R_3 R_5}{R_2(R_1 R_3 + R_1 R_5 + R_3 R_5)}$$

The current flowing in R4, towards the voltage reference, is:

$$I_4 = \frac{V_{OAn} - V_{ref}}{R_4} = (V_{OAn} - V_{ref}) \cdot \frac{R_3 R_5}{R_4 \cdot (R_1 R_3 + R_1 R_5 + R_3 R_5)}$$

Henceforth it is assumed that the electrical resistors are thus-dimensioned: R1=R2; R3=R4; R5=R6. In the following the effect of the unbalancing of the resistors is analysed. This assumption leads to the following current values:

$$I_2 = \frac{V_n - V_{OAn}}{R_1} = \frac{V_n(R_1 R_3 + R_1 R_5 + R_3 R_5) - V_{ref} R_1(R_3 + R_5) - V_p R_3 R_5}{R_1(R_1 R_3 + R_1 R_5 + R_3 R_5)}$$

$$I_4 = \frac{V_{OAn} - V_{ref}}{R_3} = (V_{OAn} - V_{ref}) \cdot \frac{R_5}{R_1 R_3 + R_1 R_5 + R_3 R_5}$$

Lastly, the current flowing in R6, towards the current output, is:

$$I_6 = I_{R_2} - I_{R_4} = \frac{(V_n - V_p) \cdot R_5(R_1 + R_3) + (V_n - V_{ref}) \cdot R_1 R_3}{R_1(R_1 R_3 + R_1 R_5 + R_3 R_5)}$$

The current at the output is:

$$V_{out} = V_{OAp} - I_{R_6} R_6 = V_{ref} + (V_p - V_n) \cdot \frac{R_5}{R_1}$$

With the aim of evaluating the circuit behaviour by inserting therein generic impedances in the place of resistors, all the electrical resistors R are replaced, in the above formulae, with corresponding impedances and, using the same assumptions, the same result is obtained:

$$V_{out} = V_{OAp} - I_{Z_6} Z_6 = V_{ref} + (V_p - V_n) \cdot \frac{Z_5}{Z_1}$$

with the advantage that it is possible to integrate appropriate filtering functions into the circuit of the invention.

A further aspect to be considered in the analysis of the circuit is the effect of the non-ideality of the resistors, primarily the "parasite elements". These elements comprise the capacitors in parallel and the inductances in series and can be can be ignored for frequencies much lower than the breakdown frequencies of the various parasite filters that form. Using a hypothesis of resistors of the order of hundreds of kΩ and capacities in the order of hundreds of pF, passbands of the order of about ten kHz are obtained, therefore considerably higher than the typical frequencies of the voltages of the cells of a battery. Further, should greater reading velocities be necessary, the divider resistance can be reduced, with an ensuing increase in the reading current and a greater potential dissipated in the divider, which can cause a thermal drift.

Proceeding with the effects of the non-ideality of the resistors, consider the case in which R2 ≠ R1. From the description of the operational amplifier without a divider in input, the unbalancing is known to have an influence on the CMRR, so that - for the sake of simplification - $V_{ref}$=0 e $V_p$=$V_n$=$V_{cm}$ are considered (common mode voltages): the results are valid due to the principle of superposing of the effects.

The voltage at the two inputs of the operational amplifier is:

$$V_{OAp} = V_{OAn} = V_{cm} \cdot \frac{R_3 R_5}{R_1 R_3 + R_1 R_5 + R_3 R_5}$$

The current in R2 becomes:

$$I_2 = V_{cm} \cdot \frac{R_1}{R_2} \cdot \frac{R_3 + R_5}{R_1 R_3 + R_1 R_5 + R_3 R_5}$$

The current in R4:

$$I_4 = V_{cm} \cdot \frac{R_3 R_5}{R_4 (R_1 R_3 + R_1 R_5 + R_3 R_5)}$$

The current in R6:

$$I_6 = V_{cm} \cdot \frac{R_1 R_3 + R_1 R_5 - R_2 R_5}{R_2 (R_1 R_3 + R_1 R_5 + R_3 R_5)}$$

The output current:

$$V_{out} = V_{cm} \cdot \frac{R_5}{R_2 (R_1 R_3 + R_1 R_5 + R_3 R_5)} \cdot (R_3 - R_5) \cdot (R_2 - R_1)$$

Thus a sensitivity to the common mode and the relative CMRR is evidenced as follows:

$$CMRR = \left| \frac{V_{cm}}{V_{out}} \right| = \left| \frac{R_1 R_3 + R_1 R_5 + R_3 R_5}{R_5 (R_3 - R_5)} \cdot \frac{R_2}{R_2 - R_1} \right|$$

As R2 tends towards R1, the CMRR tends to the infinite and $V_{out}$ to zero.

By way of example, with R1 = R5 = R6 = 220kΩ, R2 = 222.2kΩ (1% error), R3 = R4 = 12kΩ, a CMRR = 118 is obtained. With an input voltage of 100V, the output error is 850mV. It is therefore necessary to dimension the circuit in such a way that the output is, in the worst case, compatible with all the electronic chain of acquisition, and in particular with an eventual analog/digital converter downstream of the circuit.

Analysis is now made of the non-ideality of the resistors in which R4 ≠ R3. The same conditions as the preceding case are assumed, obtaining the following results:

$$V_{OAp} = V_{OAn} = V_{cm} \cdot \frac{R_3 R_5}{R_1 R_3 + R_1 R_5 + R_3 R_5}$$

$$I_2 = V_{cm} \cdot \frac{R_3 + R_5}{R_1 R_3 + R_1 R_5 + R_3 R_5}$$

$$I_4 = V_{cm} \cdot \frac{R_3 R_5}{R_4 (R_1 R_3 + R_1 R_5 + R_3 R_5)}$$

$$I_6 = V_{cm} \cdot \frac{R_3 R_4 + R_4 R_5 - R_3 R_5}{R_4 (R_1 R_3 + R_1 R_5 + R_3 R_5)}$$

$$V_{out} = V_{cm} \cdot \frac{R_5^2}{R_4} \cdot \frac{(R_3 - R_4)}{R_1 R_3 + R_1 R_5 + R_3 R_5}$$

In this case too there is a sensitivity to the common mode and the relative CMRR is:

$$CMRR = \left| \frac{V_{cm}}{V_{out}} \right| = \left| \frac{R_1 R_3 + R_1 R_5 + R_3 R_5}{R_5^2} \cdot \frac{R_4}{R_3 - R_4} \right|$$

As R3 tends towards R4, the CMRR tends towards the infinite, while $V_{out}$ tends to zero.

By way of example, with R1=R2=R5=R6=220kΩ, R3=12kΩ and R4=12.12kΩ (1% error), the result is CMRR=112. With an input voltage of 100V, the output error is 890mV.

There follows an analysis of the non-ideality of the resistor in which R6 ≠ R5. The same conditions as in the preceding cases are assumed, giving:

$$V_{OAp} = V_{OAn} = V_{cm} \cdot \frac{R_3 R_5}{R_1 R_3 + R_1 R_5 + R_3 R_5}$$

$$I_2 = V_{cm} \cdot \frac{R_3 + R_5}{R_1 R_3 + R_1 R_5 + R_3 R_5}$$

$$I_4 = V_{cm} \cdot \frac{R_5}{R_1 R_3 + R_1 R_5 + R_3 R_5}$$

$$I_6 = V_{cm} \cdot \frac{R_3}{R_1 R_3 + R_1 R_5 + R_3 R_5}$$

$$V_{out} = V_{cm} \cdot (R_5 - R_6) \cdot \frac{R_3}{R_1 R_3 + R_1 R_5 + R_3 R_5}$$

This case too shows a common mode sensitivity and the relative CMRR is:

$$CMRR = \left| \frac{V_{cm}}{V_{out}} \right| = \left| \frac{R_1 R_3 + R_1 R_5 + R_3 R_5}{R_3} \cdot \frac{1}{R_5 - R_6} \right|$$

As R5 tends towards R6, the CMRR tends towards the infinite, while $V_{out}$ tends to zero.

By way of example, with R1 = R2 = R6 = 220kΩ, R5 = 217,8kΩ e R3 = R4 = 12kΩ, the result is CMRR = 2014. In this way the tolerance of the imbalance is much better than in the preceding cases. With an input voltage of 100V, the output error is 50mV.

Further aspects to be considered in the analysis of the circuit are represented by the effects of non-ideality of the voltage sources, the analog switches and the operational amplifier.

The series resistance to the voltage generator, for example the internal resistance of the battery cells, with the tolerance from one generator to the other, acts by unbalancing the R1/R2 relation. Therefore the description deals with a case of non-ideality of the resistors R1≠R2. It should be noted that the internal resistances of the cells are of the order of mΩ, i.e. from eight to nine orders of magnitude  smaller than the typical resistors of the switched operational amplifier.

The analog switches introduce a resistance in series to R1 and R2, and therefore each unbalancing is to be treated as in the case of non-ideality R1≠R2. Further, the switches introduce parasite capacities, in the order of tens of pF, so that the treatment is the same as for the parasite elements of the resistors. The bulk diode of a MOFSET as an analog switch, on the other hand, enables circulation of leakage currents in the case of negative input tensions. To obviate this problem, a relay can be used as an analog switch, adding to the circuit a second analog switch MOSFET in series to what is shown, but with swapped drain and source, such as to prevent any circulation of unforeseen current, using a photoMOS or design the circuit such that the tensions to be measured are always positive with respect to the mass of the circuit.

As regards the effects of the non-ideality of the operational amplifier, various phenomena must be considered. Firstly, the offset voltage of the operational amplifier can be modelled as a voltage generator in series with one of the two inputs of the amplifier. Assuming that $V_p = V_n = V_{ref} = 0$, all the relations between the resistors as ideal (R1=R2, R3=R4, R5=R6) the superposition principle effect is applied. It is further observed that the negative terminal of the voltage generator is connected to a virtual mass, given that no current passes in R1, R3 or R5, since the operational amplifier input does not emit current. The circuit thus becomes a non-inverting amplifier, having $V_{os}$ as input, the offset voltage. The following can be deduced:

$$V_{out} = V_{os} \cdot \left( 1 + \frac{R_6}{R_2 \parallel R_4} \right) = V_{os} \cdot \left( 1 + G + G \frac{R_2}{R_4} \right) \approx V_{os} \cdot G \cdot \frac{R_2}{R_4}$$

in which G represents the stage gain in the ideal case (R5/R1) and the estimate is valid when R2 is much greater than R4, a common case when the stage is dimensioned such as to accept high common mode voltages. The effect is to amplify the offset voltage. It is thus necessary to select the components having an offset voltage that is small and stable, such as to make it easily calibratable (and compensatable) using software.

Among the effects of non-ideality of the operation amplifier, it is significant how the currents in input to the operational amplifier generate voltages on the resistors connected thereto. Therefore it is necessary to choose components having very limited parasite currents, of the order of the pA, such as to generate on the resistors the lowest possible error (of the order of $\mu$V). This voltage error is then amplified in a similar way to the offset voltage, but is typically insignificant with respect thereto.

As regards the passband of the amplifier, in order not to degrade the performances of the circuit an operational amplifier should be chosen which has a gain-band product such as to guarantee a passband that is much higher than the maximum frequency of interest. The gain to be kept in  consideration is:

$$\left(1 + G + G\,\frac{R_2}{R_4}\right) \approx G \cdot \frac{R_2}{R_4}$$

Further, as the operational amplifiers function correctly only if the voltages applied to the inputs are comprised between the supply voltages of the integrated circuit, it is necessary to dimension the resistors R3 and R4 such as to bring the input voltages within the supply range.

Lastly, in order to guarantee the stability of the whole circuit, the amplifier must be stable with a single gain.

Figure 5 illustrates a further embodiment of the circuit of the present invention, illustrated in a circuit diagram which shows components and connections.

In this embodiment, alternative to the embodiment of figure 4 but equally derived from the general diagram of figure 1, the circuit comprises a first VpN and a second Vp(N-1) input, destined to be connected respectively to a first voltage source and a second voltage source upstream of the circuit, and said electronic amplifier is an instrumentation amplifier (denoted in its entirety by way of example with the reference numerals of the three operational amplifiers U7, U8, U9, but realizable also with only two operational amplifiers, or even using a single block instrumentation amplifier).

In this embodiment, the positive input terminal and the negative input terminal of the instrumentation amplifier (respectively coinciding with the positive terminal of the operational amplifier U8 and the positive terminal of the operational amplifier U7) are electrically connected respectively with the first and second inlet.

The circuit further comprises a first voltage divider R1,N, R2,N interposed between, and connected with, the first inlet and the positive input terminal, and a second voltage divider R1,N-1, R2,N-1 interposed between, and connected to, the second input and the negative input terminal.

The circuit preferably further comprises a first analog switch MN and a second analog switch MN-1, connected in series respectively to the first and the second voltage divider. The first and the second analog switches are selectively and independently operable at least between the closed and open positions, in order to enable or interrupt the passage of electric current from the respective input to the instrumentation amplifier.

The first and the second inputs are preferably electrically connected respectively to the first and second voltage sources upstream of the circuit, the first and the second voltage sources being respectively the output terminal of a cell of a battery and the output terminal a successive cell of the same battery.

The first voltage divider preferably comprises a first R1,N and a second electrical resistor R2,N operatively and logically connected in series with the first input, and the second voltage divider  comprises a respective first R1,N-1 and a respective second electric resistor R2,N-1 connected in series to the second input. Note that, as seen herein above, in this case too the resistors R1,N and R2,N, like the pair of resistors R1,N-1 and R2,N-1, are not electrically in series but are however to be considered "in series" from the logical and flow of information point of view.

The positive input terminal of the instrumentation amplifier is connected in an intermediate position between the first and the second electrical resistor of the first voltage divider, and the negative input terminal of the instrumentation amplifier is connected in an intermediate position between the respective first and second electrical resistor of the second voltage divider.

The instrumentation amplifier preferably comprises a first operational amplifier U8, having the respective positive input terminal connected to said first circuit input, a second operational amplifier U7, having the respective positive input terminal connected to said second circuit input, and a third operational amplifier U9 located downstream of said first and second operational amplifiers and having the respective positive input terminal connected to the output of the first operational amplifier, via an electrical resistor RD3,N and the respective negative input terminal connected to the output of the second operational amplifier, via a respective electrical resistor RD4,N.

The first U8, the second U7 and the third operational amplifier U9 preferably have a respective feedback line, connecting the respective output to the respective negative input terminal, comprising a respective feedback electrical resistor RD1,N, RD2,N and RD6,N.

The first and second operational amplifiers have the respective negative input terminals connected to one another via a gain electrical resistor RG,N.

At the base of the two described embodiments lies a single inventive concept; in fact, the instrumentation amplifier can be considered a derivative of the operational amplifier: with respect thereto it exhibits two extra operationals which improve (by increasing) the inlet impedance of the circuit and enable varying the amplification of the input differential signal (difference between the voltages of the first and second inlet) by varying only one component thereof, i.e. the gain electrical resistor RG,N.

The unifying inventive concept thus lies in the general diagram which includes a divider that can be switched by switches, followed by an analog processing block (amplifier), which calculates the difference in the analog domain and not in the digital one.

The circuit probably comprises a voltage reference (which constitutes a circuit inlet) connected at a point common to the output of the first operational amplifier and to the positive input terminal of the third operational amplifier, and a fifth electrical resistor RD5,N interposed in series between the voltage reference and the positive input terminal of the third amplifier. The voltage reference is preferably connected at a point downstream of the electrical resistor RD3,N.

The first analog switch is preferably interposed in series between the first R1, N and the second R2,N electrical resistor of the first voltage divider, and the second analog switch is interposed in series between the respective first R1, N-1 and the respective second electrical resistor R2,N-1 of the second voltage divider.

The first analog circuit preferably further comprises an independent enabling or selection line (Abil) connected to the first and second analog switch such as to determine the passage thereof between the open condition and the closed condition.

The circuit preferably comprises a plurality of instrumentation amplifiers linked in succession such that the first input of an amplifier is electrically connected to the second input of the successive amplifier and the first input of the successive amplifier is electrically connected to the second input of the next successive amplifier, and further comprises a plurality of inputs in which a first input is connected to the negative input terminal of the first instrumentation amplifier, a second input is connected to the positive input terminal of the first instrumentation amplifier and to the negative input terminal of the successive amplifier, and a third input is connected to the positive input terminal of a next successive instrument amplifier, said scheme being repeatable for a plurality of successive voltage inputs destined to be connected to successive cells of a battery.

This is the case of figure 5, in which the circuit comprises a further instrumentation amplifier comprising the three operational amplifiers denoted by U1, U2 and U3. This further amplifier receives at the positive terminal input the voltage VpN+1 in arrival from a successive cell (or preceding cell on the basis of the path direction of the cells) to cell N, while it receives in input to the negative terminal the tension VpN of the Nth cell, also connected to the positive terminal of the adjacent amplifier U7-U8-U9. The Applicant has found that the architecture of the circuit with the operational amplifier advantageously enables minimizing the number of analog switches and enables sharing the dividers between a plurality of cells; it further enables multiplexing a single or a small number, of instrumentation amplifiers, among many adjacent cells.

In the following a details description and analysis is made of the functioning of the electronic circuit in the embodiment which includes the use of an instrumentation amplifier, with particular reference to the transfer functions between the inlets and the outlets, the relations between voltages, currents and resistors, and the effects of the non-ideality of the components of the circuit.

The analysis of the second embodiment is simplified with respect to that of the first, as the currents coming from the current sources flow only into the resistors of the dividers and are not a part of the feedback. This enables separate consideration of the contributions of the divider and the instrumentation amplifiers.

In this case it is advantageous to assume that all the dividers have the same damping effect, and that the switches and the amplifiers are ideal. It is primarily necessary to dimension the dividers such that in the worst case the maximum voltages applicable to the instrumentation amplifier inputs are not exceeded.

At the output of each divider, considering the positive input of the cell B, the current as expressed below is present:

$$Vpart_N = Vp_N \cdot \frac{R_{2,N}}{R_{1,N}+R_{2,N}} = Vp_N \cdot k_N,$$

in which the parameter "k" defines the damping of the divider.

The voltage detected at the input of the instrumentation amplifier processing the voltage of the cell N is:

$$Vdiffpart_N = (Vp_N - Vp_{N-1}) \cdot k_N,$$

in which all the upper resistors of the dividers are equal to R1 and all the lower resistors are equal to R2. The voltage at the output of the instrumentation amplifier is:

$$Vout_N = Vref + G \cdot k \cdot (Vp_N - Vp_{N-1}),$$

where G indicates the gain of the instrumentation amplifier, which is:

$$G = \left(1 + \frac{2R_{D1}}{R_G}\right) \cdot \frac{R_{D5}}{R_{D3}},$$

In this relation RD1=RD2, RD3=RD4, RD5=RD6 is considered for the amplifier of each cell. The following can be selected:

$$G = \frac{1}{k} = 1 + \frac{R_1}{R_2},$$

with the aim of obtaining, at the output of each amplifier, a current value that is equal to the current difference between a cell and the preceding cell, both entering the amplifier:

$$Vout_n = Vp_N - Vp_{N-1}$$

The scope of protection embraces, and considers technically equivalent, any embodiment of the present invention in which the circuit comprises an instrumentation amplifier, in any form, including single-block, that exhibits the first input, the second input, the voltage output and one or more operational amplifiers.

As in the first embodiment, an aspect to be considered in the analysis of the circuit is represented by the effects of the non-ideality of the resistors, i.e. the presence of parasite elements (parallel capacitors and series inductances): these elements can be not considered for frequencies much lower than breakdown frequencies of the various parasite filters that form in the circuit. Considering, as hypotheses, resistors of the order of hundreds of kΩ and capacitors of the order of hundreds of pF, passbands are obtained of the order of about ten kHz, thus considerably superior to the typical frequencies of the voltages of the cells of a battery.

In relation to the dividers, a possible unbalancing thereof, i.e. a case in which the upper resistors are not all identical to one another (the same goes for the lower resistors), that is the factors "k" previously defined are not identical for all the dividers, introduces a sensitivity to the common mode beyond a gain error.

Assuming that the positive pole of the cell N is processed by an ideal divider, with damping k, while the negative (which is also the positive of the preceding cell N-1) is processed with a damping k(1+ε), the voltages of the two poles can be written in common mode and differential terms as:

$$Vp_N = Vcm_N + \frac{Vdm_N}{2}, Vn_N = VpN - 1 = Vcm_N - \frac{Vdm_N}{2}$$

The voltage at the input of the relative instrumentation amplifier is:

$$Vdiffpart_N = -Vcm_N \cdot k \cdot \varepsilon + Vdm_N \cdot \left(k + \frac{k \cdot \varepsilon}{2}\right),$$

if ε=0, the ideal case formula will obtain. The following will be obtained at the output of the instrumentation amplifier:

$$Vout_N = -Vcm_N \cdot \varepsilon + Vdm_N + Vdm_N \cdot \left(\frac{G \cdot \varepsilon}{2}\right),$$

in which the fact that G = 1/k is exploited. Therefore there is a gain error and a common mode error is introduced, with the corresponding rejection ratio:

$$CMRR = \frac{1}{\varepsilon}$$

Further aspects to be considered in the analysis of the circuit are represented by the effects of the non-ideality of the current sources, the analog switches and instrumentation amplifier.

As for the voltage sources, if the cells have a non-null internal resistance, this adds to the upper resistors of the dividers, introducing an error $\varepsilon$. Taking the orders of magnitude into consideration, this error can be ignored as the internal resistances of the cells are of the order of m$\Omega$, while the upper resistors of the dividers are of the order of k$\Omega$ or indeed M$\Omega$.

As for the parasite resistances in series with the switches, note that the worst case is the one involving the MOSFETs, in which it can reach a few tens of $\Omega$ (25$\Omega$ for the commercial product known with the code ZVN3320). In this case too the upper resistances of the dividers are decidedly larger (at least four orders of magnitude) with respect to the parasite resistance considered. The CMRR introduced by the MOSFETs will therefore be limited to about 10000, much better than the one introduced by the tolerances of the upper resistors (0.1%, and therefore CMRR limited to 1000, unless very precise and expensive resistors are used). The variation of the channel resistances with the temperature can be estimated in a doubling for a temperature increase of 50°C. In this case too (also, difficult to obtain in a case of a correctly designed battery), the CMRR is not limited to the analog switches, and in any case a dependence on the temperature is introduced which is difficult to observe with the analog/digital converter with which the microswitches are normally equipped (10-12bit, that is a part on 1024 or 4096, respectively).

The parasite capacity of the switch introduces a parasite filter and a dependence of the CMRR on the frequency, but due to the considerations expressed herein above, the effects of these filters become appreciable only from the about-ten kHz and above.

As for the non-ideality of the instrumentation amplifier, the offset voltage is summed to the input voltage at the instrumentation amplifier and is thus amplified with the same gain (G).

Taking as a hypothesis a battery having twenty lithium cells (84V at rated full charge), and wishing to limit the voltage at the input of the amplifier to 5V, a damping k=1/20 and a corresponding G=20, an error of 20mV is implied for each mV of offset voltage. This value can easily be compensated during the calibration step. It is important to select or design the instrumentation amplifier such that the variation of the offset voltage with temperature, moisture and ageing is contained within a few tens of $\mu$V, such that the overall error is of less than 1mV.

By selecting amplifiers with FET inputs and considering that the input currents generate errors in voltage due to the flowing thereof in parallel between R1 and R2 (the upper and lower resistors of the dividers), the error introduced before the instrumentation amplifier can be evaluated at about ten nV, and is therefore insignificant with respect to the error due to the offset voltage. Also in the case of currents of the order of nA (typical of amplifiers with BJT input), errors are obtained that are comparable to those due to offset voltages.

Lastly, the stability of the instrumentation amplifier is not influenced by the dimensioning of the divider, as it does not participate in the feedback network.

The circuit of the present invention can be realised in both integrated form and with discrete components.

**Claims**

1. An electronic circuit (1), in particular for a battery management system, the circuit comprising:

   - at least an input (Vn; Vp), destined to be connected to a voltage source located upstream of the circuit;
   - at least an electronic amplifier (10), provided with at least a positive input terminal (11), a negative input terminal (12) and a voltage output (13), said at least an input being electrically connected to said positive input terminal or said negative input terminal;
   - at least a voltage divider (20) interposed between, and connected with, said at least an input and one from among said positive input terminal and said negative input terminal;
   the circuit further comprising at least an analog switch (30) operatively connected in series to said at least a voltage divider and selectively operable at least between a closed condition, in which it enables passage of electric current from said at least an input to said electronic amplifier, and an open condition, in which it interrupts passage of electric current from said at least an input to said electronic amplifier,
   said at least an analog switch (30) being preferably a bipolar junction transistor (BJT), a field effect transistor (FET) or a relay.

2. The circuit of claim 1, comprising a positive input (Vp) and a negative input (Vn), destined to be connected respectively to a source of positive voltage and a source of negative voltage upstream of the circuit, and said electronic amplifier is an operational amplifier (U1),
where the positive input terminal and the negative input terminal of the operational amplifier are electrically connected respectively with said positive input and said negative input,
the circuit further comprising a first voltage divider (R1, R3) interposed between, and connected with, the positive input (Vp) and said positive input terminal, and a second voltage divider (R2, R4) interposed between, and connected with, the negative input (Vn) and said negative input terminal,
the circuit further comprising a first analog switch (M1) and a second analog switch (M2) which are part of the series constituting respectively said first voltage divider and said second voltage divider, said first and second analog switches being selectively and independently operable at least between said closed condition and said open condition, respectively to enable or interrupt passage of electric current via said divider and to selectively provide the operational amplifier with a valid signal for the measurement from the respective input to said operation amplifier.

3. The circuit of claim 2, wherein said positive input (Vp) and said negative input (Vn) are electrically connected respectively to said source of positive voltage and said source of negative voltage upstream of the circuit, the sources of positive and negative voltage being the output terminals of a battery or of a single cell of a battery, where such output terminals of the battery are two positive sources, one of which being greater than the other, and said sources of positive and negative voltage are respectively the greater and the lesser of the two voltages of the battery, and/or wherein said first voltage divider comprises a first (R1) and a third (R3) electrical resistor operatively and logically connected in series with said positive input (Vp) and said second voltage divider comprises a second (R2) and a fourth (R4) electrical resistor connected in series to said negative input (Vn), said positive input terminal of the operation amplifier being connected in an intermediate position between said first and said third electrical resistor, and said negative input terminal of the operation amplifier being connected in an intermediate position between said second and said fourth electrical resistor, and/or wherein the circuit comprises a voltage reference (Vref), connected to the positive input terminal of the operational amplifier, and a fifth electrical resistor (R5) interposed in series between the voltage reference and the positive input terminal, the voltage reference preferably being connected at a common point downstream of said third and said fourth electrical resistor.

4. The circuit of claim 2 or 3, comprising a feedback line (40) connecting the voltage output (13) and the negative input terminal of the operational amplifier, and comprising, in series with said feedback line, a sixth electrical resistor (R6), and/or wherein said first analog switch (M1) is interposed in series between said first and said third electrical resistors and said second analog switch (M2) is interposed in series between said second and said fourth electric resistors, and/or wherein the circuit comprises an independent supply line connected to said first (M1) and/or said second analog switch (M2) for determining passage between the open condition and the closed condition.

5. The circuit of claim 1, comprising at least a first (VpN) and a second (Vp(N-1)) input, destined to be connected respectively to a first voltage source and a second voltage source upstream of the circuit, and said electronic amplifier is an instrumentation amplifier (U7, U8, U9),
where the positive input terminal and the negative input terminal of the instrumentation amplifier are electrically connected respectively with said first input and said the second input,
the circuit further comprising a first voltage divider (R1,N, R2,N) interposed between, and connected with, the first inlet (VpN) and said positive input terminal, and a second voltage divider (R1,N-1, R2,N-1) interposed between, and connected to, the second input (Vp(N-1)) and said negative input terminal, the circuit further comprising a first analog switch (MN) and a second analog switch (MN-1), configured for selectively interrupting respectively said first voltage divider and said second voltage divider, said first and second analog switches being selectively and independently operable at least between said closed condition and said open condition, for respectively enabling or interrupting passage of electric current through the respective divider and for selectively supplying a valid measurement signal from the respective input to the instrumentation amplifier to said instrumentation amplifier.

6. The circuit of the preceding claim, wherein said first and said second inputs are electrically connected respectively to said first and said second voltage sources upstream of the circuit, the first and the second voltage sources being respectively the output terminal of a cell of a battery and the output terminal of a successive cell of the same battery, and/or wherein the first voltage divider comprises a first (R1,N) and a second electrical resistor (R2,N) operatively and logically connected in series with said first input, and the second voltage divider comprises a respective first (R1,N-1) and a respective second electric resistor (R2,N-1) operatively and logically connected in series with said second input, where the positive input terminal of the instrumentation amplifier is connected in an intermediate position between the first and the second electrical resistor of the first voltage divider, and the negative input terminal of the instrumentation amplifier is connected in an intermediate position between the respective first and second electrical resistor of the second voltage divider.

7. The circuit of claim 5 or 6, wherein the instrumentation amplifier comprises a first operational amplifier (U8), having the respective positive input terminal connected to said first circuit input, a second operational amplifier (U7), having the respective positive input terminal connected to said second circuit input, and a third operational amplifier (U9) located downstream of said first and second operation amplifiers and having the respective positive input terminal connected to the output of the first operational amplifier, via an electrical resistor (RD3,N) and the respective negative input terminal connected to the output of the second operational amplifier, via a respective electrical resistor (RD4,N), and/or wherein the first (U8), the second (U7) and the third operational amplifier (U9) have a respective feedback line, connecting the respective output to the respective negative input terminal, comprising a respective feedback electrical resistor (RD1,N, RD2,N and RD6,N), and/or wherein said first and said second operational amplifiers have the respective negative input terminals connected to one another via an gain electrical resistor (RG,N).

8. The circuit of any one of claims from 5 to 7, comprising a voltage reference (Vref), connected at a point which is common to the output of the first operational amplifier and to the positive input terminal of the third operational amplifier, and a fifth electrical resistor (RD5,N) interposed in series between the voltage reference and the positive input terminal of the third amplifier, the voltage reference being connected preferably at a point downstream of the electrical resistor (RD3,N), and/or wherein said first analog switch (MN) is interposed in series between the first (R1,N) and the second electrical resistor (R2,N) of the first voltage divider, and said second analog switch (MN-1) is interposed in series between the respective first (R1,N-1) and the respective second electrical resistor (R2,N-1) of the second voltage divider, and/or wherein the circuit comprises an independent supply line connected to said first and said second analog switches for determining the passage between the open condition and the closed condition.

9. The circuit of any one of claims from 5 to 8, comprising a plurality of instrumentation amplifiers linked in succession such that the first input of an amplifier is electrically connected to the second input of the successive amplifier and the first input of the successive amplifier is electrically connected to the second input of the next successive amplifier, and further comprises a plurality of inputs in which a first input is connected to the negative input terminal of the first instrumentation amplifier, a second input is connected to the positive input terminal of the first instrumentation amplifier and to the negative input terminal of the successive amplifier, and a third input is connected to the positive input terminal of a next successive instrument amplifier, said scheme being repeatable for a plurality of successive voltage inputs destined to be connected to successive cells of a battery.

10. A battery management system comprising a plurality of electronic circuits according to any one of the preceding claims, each being destined to be connected to a respective cell of an electric battery.

FIG.1

FIG.2

FIG.3

FIG.4

FIG.5

Europäisches
Patentamt

European
Patent Office

Office européen
des brevets

**EUROPEAN SEARCH REPORT**

Application Number

EP 13 16 3782

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 104 164 A (IINO JUNICHI [JP] ET AL) 15 August 2000 (2000-08-15) * column 3, line 15 - column 5, line 18; figures 1,4,5 * | 1-10 | INV. G01R15/04 G01R31/36 |
| X | US 2004/160229 A1 (FUJITA HIROSHI [JP] ET AL) 19 August 2004 (2004-08-19) | 1-8,10 | |
| A | * paragraph [0048] - paragraph [0053]; figure 2 * | 9 | |
| X | US 2009/176146 A1 (MATSUURA SHINICHI [JP] ET AL) 9 July 2009 (2009-07-09) | 1,10 | |
| A | * paragraph [0020] - paragraph [0025]; figure 1 * | 2-9 | |
| X | US 2010/052419 A1 (OOSAWA TAKESHI [JP] ET AL) 4 March 2010 (2010-03-04) * the whole document * | 1-10 | |
| X | US 2004/051534 A1 (KOBAYASHI TETSUYA [JP] ET AL) 18 March 2004 (2004-03-18) | 1-8,10 | TECHNICAL FIELDS SEARCHED (IPC) |
| A | * figure 8 * | 9 | G01R |
| A | US 2005/110464 A1 (BAKER HOWARD S [US]) 26 May 2005 (2005-05-26) * the whole document * | 1-10 | |

The present search report has been drawn up for all claims

| Place of search | Date of completion of the search | Examiner |
|---|---|---|
| Munich | 12 July 2013 | Jedlicska, István |

EPO FORM 1503 03.82 (P04C01)

## ANNEX TO THE EUROPEAN SEARCH REPORT
## ON EUROPEAN PATENT APPLICATION NO.

EP 13 16 3782

This annex lists the patent family members relating to the patent documents cited in the above-mentioned European search report.
The members are as contained in the European Patent Office EDP file on
The European Patent Office is in no way liable for these particulars which are merely given for the purpose of information.

12-07-2013

| Patent document cited in search report | Publication date | Patent family member(s) | | Publication date |
|---|---|---|---|---|
| US 6104164 A | 15-08-2000 | NONE | | |
| US 2004160229 A1 | 19-08-2004 | JP | 4131394 B2 | 13-08-2008 |
| | | JP | 2004251708 A | 09-09-2004 |
| | | US | 2004160229 A1 | 19-08-2004 |
| US 2009176146 A1 | 09-07-2009 | CN | 101459267 A | 17-06-2009 |
| | | JP | 2009145139 A | 02-07-2009 |
| | | TW | 200925628 A | 16-06-2009 |
| | | US | 2009176146 A1 | 09-07-2009 |
| | | US | 2013002261 A1 | 03-01-2013 |
| US 2010052419 A1 | 04-03-2010 | CN | 101659217 A | 03-03-2010 |
| | | JP | 2010054468 A | 11-03-2010 |
| | | US | 2010052419 A1 | 04-03-2010 |
| US 2004051534 A1 | 18-03-2004 | JP | 3791767 B2 | 28-06-2006 |
| | | JP | 2002357624 A | 13-12-2002 |
| | | US | 2004051534 A1 | 18-03-2004 |
| US 2005110464 A1 | 26-05-2005 | NONE | | |

EPO FORM P0459

For more details about this annex : see Official Journal of the European Patent Office, No. 12/82